# EUROPÄISCHE PATENTSCHRIFT

(11) **EP 0 419 949 B1**
(45) Veröffentlichungstag und Bekanntmachung des Hinweises auf die Patenterteilung: **09.02.1994**
(21) Anmeldenummer: 90117600.8
(22) Anmeldetag: 12.09.1990
(51) Int. Cl.: H05K 9/00

(54) **Etagenschirmblech für einen Baugruppenträger**
Rack stage shield sheet
Tôle de blindage d'étage de rack électronique

(30) Priorität: 25.09.1989 DE 8911405 U
(43) Veröffentlichungstag der Anmeldung: 03.04.1991
(73) Patentinhaber: SIEMENS AKTIENGESELLSCHAFT, 80333 München (DE)
(72) Erfinder: Assel, Eugen, Dipl.-Ing. (FH), D-8729 Knetzgau (DE); Gebhard, Bruno, Dipl.-Ing. (FH), D-8550 Forchheim (DE)

(56) Entgegenhaltungen:
- EP-A- 0 315 798
- DE-U- 8 422 589
- DE-U- 8 901 676

## Beschreibung

Die Erfindung bezieht sich auf ein Etagensshirmblech für einen Baugruppenträger zur Abschirmung von hochfrequenten, elektromagnetischen Störfeldern, von den im Baugruppenträger eingesteckten Steckbaugruppen mit niedrigen Versorgungsspannungen und Signalpegeln.

Aus dem Katalog ET 1.1 mit dem Titel "Einbausystem ES 902C 19-Zoll-Bauweise" der Firma Siemens AG, Ausgabe 1987, Bestell-Nr. E86010-K4101-A211-A1, sind Etagenschirmbleche für einen Baugruppenträger bekannt. Jedes Etagenschirmblech ist allseitig gekantet. Die stirnseitigen Abkantungen des Etagenschirmbleches enthalten eingepreßte Muttern für Sperrzahnschrauben. Verschraubt werden kann dieses Etagenschirmblech mit den Seitenteilen des Baugruppenträgers. Um die elektrische Leitfähigkeit zwischen Etagenschirm und Trägerkomponenten zu erhöhen, wird das Etagenschirmblech umlaufend mit einer Dichtungsschnur bzw. einem Kontaktstreifen versehen. Nachteilig bei diesem Etagenschirmblech ist es, daß keine hohen Dämpfungswerte erreicht werden bzw. die Grenzfrequenz, die von den Steckbaugruppen abgeschirmt werden soll, nicht sehr hoch ist.

Zur Erzielung hoher Schirmdämpfungswerte in einem Frequenzbereich kleiner dem Gigaherz-Bereich (GHz-Bereich) werden Etagenschirmbleche ohne Entlüftungslöcher eingesetzt. Außerdem sind die Frontseite und die Rückseite des Baugruppenträgers mit einer Frontplatte und mit einem Verdrahtungsschirmblech versehen. Dabei sind die einzelnen Teile miteinander verschraubt, wobei Höchstfrequenzdijchtung, insbesondere solche aus Metallgewebe, in den Trennfugen der Gehäuseabdeckungen angeordnet sind. Nachteilig bei einer derartigen Abschirmung ist es, daß die Entwärmung des Gehäuseinnern nur über die Gehäusewände abgestrahlt werden kann.

Es ist ferner bekannt, zur Belüftung des Gehäuseinnern elektrischer Gehäuse, Filtervorrichtungen mit wabenartigen Luftdurchtrittsöffnungen vorzusehen, die eine ausreichende Abschirmung gegenüber Hochfrequenzfeldern bilden.

Jedoch kann eine derartige Abschirmung nur dann wirksam sein, wenn die Filtervorrichtung mit den wabenförmigen Öffnungen, sowie alle Zubehörteile, die die Befestigung dieser Filtervorrichtung auf dem Gehäuse sichern, elektrisch mit dem Gehäuse einwandfrei verbunden sind, um eine durchgehende metallische Struktur zu bilden, bei der alle zur Bildung dieser Struktur eingesetzten Metallteile flächenhaft elektrisch miteinander verbunden sind.

Außerdem erhöht diese Filtervorrichtung mit den wabenförmigen Öffnungen das Gehäuse in Abhängigkeit der Grenzfrequenz, die abgeschirmt werden soll. Ferner verteuert sich das elektrische Gerät alleine schon durch die Filteranordnung mit den wabenförmigen Öffnungen.

Der Erfindung liegt nun die Aufgabe zugrunde, das eingangs genannte perforierte Etagenschirmblech dahingehend zu verbessern, daß hohe schirmdämpfungswerte erreicht werden.

Diese Aufgabe wird erfindungsgemäß dadurch gelöst, daß das Etagenschirmblech für einen Baugruppenträger zur Abschirmung von hochfrequenten, elektromagnetischen Störfeldern, aus einem U-förmigen Profil besteht, dessen Schenkel jeweils als Querschienen mit einem Längsgewinde ausgebildet sind und dessen perforiertes Stegblech auf der den Schenkeln ab gewandten Seite parallel zueinander und parallel zu den Schenkeln angeordnete Längsstege aufweist, die jeweils ein Kernloch aufweisen, wobei die Dicke des Stegbleches und die Auslegung dessen Stanzlochbildes von den Dämpfungs- und Entwärmungsanforderungen der im Baugruppenträger angeordneten Steckbaugruppen abhängig sind.

Durch diese Ausgestaltung des Etagenschirmbleches kann dieses Etagenschirmblech durch einfaches Ablängen in vorbestimmten Teilungsschritten von einem Alu-Strangpreßprofil erstellt werden. Bei der Berücksichtigung von Dämpfungs- und Entwärmungsanforderungen ist die Dicke des Stegbleches so bemessen, daß das Lochbild in das Stegblech gestanzt werden kann, wodurch das Stanzlochbild wirtschaftlich erstellt wird. Mittels der Kernlöcher in den Längsstegen kann das Etagenschirmblech direkt mit den Seitenteilen des Baugruppenträgers verschraubt werden, wodurch die Steifigkeit des Baugruppenträgers erhöht wird. Außerdem wird durch die Längsstege ein Durchbiegen von Führungsschienen im Baugruppenträger verhindert. Vorderseitige und rückseitige Abschirmbleche können mittels selbstformender Schrauben in den beidseitigen Längsgewinden der als Querschienen ausgebildeten Schenkeln des Etagenschirmbleches mechanisch und elektrisch leitend mit dem Etagenschirmblech verbunden werden. Das Etagenschirmblech wird mittels Schrauben mit einer vorderen und hinteren Querschiene des Baugruppenträgers mechanisch und elektrisch leitend verbunden. Die Dämpfung kann über den Schraubenabstand variiert werden. Um die Dämpfung noch zu erhöhen, werden Dichtungsschnüre bzw. Kontaktstreifen in den Trennfugen angeordnet.

Bei einer vorteilhaften Ausführungsform des Etagenschirmbleches sind auf der Seite des perforierten Stegbleches im Bereich der Schenkel parallel zu den Längsstegen eine vordere und eine hintere Querschiene eines Baugruppenträgers einstückig angeordnet. Dadurch wird die Festigkeit des Baugruppenträgers erhöht bei gleichzeitiger Erhöhung des Dämpfungswertes, da das Etagenschirmblech nur noch mit den Seitenteilen des Baugruppenträgers verschraubt sein muß.

Bei einer weiteren vorteilhaften Ausführungsform des Etagenschirmbleches ist wenigstens ein weiteres zusätzliches perforiertes Blech vorgesehen, dessen Stanzlochbild und Abmessungen denen des Stegbleches entsprechen, wobei das Blech und das Stegblech mittels in den Stanzlöchern eingesetzter Rohrnieten miteinander mechanisch und elektrisch leitend verbunden sind. Durch die Paketierung von zusätzlichen Blechen auf dem Stegblech des Etagenschirmbleches kann die Dicke des Stegbleches und die Dicke jedes zusätzlichen Blechs so gewählt werden, daß das Lochbild immer gestanzt werden kann. Somit kann das Etagenschirmblech an jede Grenzfrequenz angepaßt werden.

Zur weiteren Erläuterung der Erfindung wird auf die Zeichnung Bezug genommen, in der mehrere Ausführungsbeispiele eines Etagenschirmbleches nach der Erfindung schematisch veranschaulicht sind.
- Figur 1: zeigt eine erste Ausführungsform des erfindungsgemäßen Etagenschirmbleches, in
- Figur 2: ist eine zweite Ausführungsform des Etagenschirmbleches dargestellt und
- Figur 3: veranschaulicht einen Ausschnitt aus einem Baugruppenträger mit einem Etagenschirmblech mit zusätzlichen Blechen.

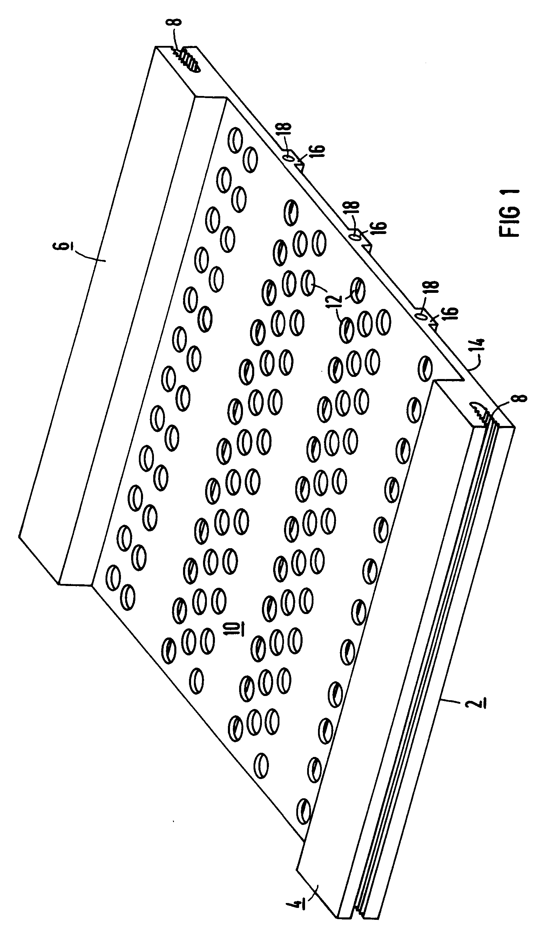

In Figur 1 ist ein erfindungsgemäßes Etagenschirmblech 2 für einen Baugruppenträger, der wegen der Übersichtlichkeit nicht dargestellt ist, zur Abschirmung von hochfrequenten, elektromagnetischen Störfeldern dargestellt. Dieses Etagenschirmblech 2 soll hochfrequente elektromagnetische Störfelder mit einem Frequenzbereich ≦ GHz-Bereich von im Baugruppenträger eingesteckten Steckbaugruppen mit niedrigen Versorgungsspannungen und Signalpegeln abhalten, wobei die Störströme von den Abschirmkomponenten auf die Trägerkomponenten des Baugruppenträgers abfließen.

Das Etagenschirmblech 2 besteht aus einem U-förmigen Profil, insbesondere einem Alu-Strangpreßprofil, das vom laufenden Meter in bestimmten Teilungsschritten abgelenkt ist. Die Schenkel 4 und 6 des U-förmigen Profils sind jeweils als Querschienen mit einem Längsgewinde 8, auch Gewindenut genannt, ausgestaltet. Das Stegblech 10 des U-förmigen Profils ist mit Löchern 12 versehen, die zur Entwärmung der Steckbaugruppen im Baugruppenträger dienen. Die Auslegung des Lochbildes ist abhängig vom vorbestimmten Schirmdämpfungswert und von den Entwärmungsanforderungen der Steckbaugruppen. Aus wirtschaftlichen Gründen sind die Löcher 12 in das Stegblech 10 gestanzt. Die den Schenkeln 4 und 6 abgewandte Seite 14 des Stegblechs 10 weist parallel zueinander und parallel zu den Schenkeln 4 und 6 angeordnete Längsstege 16 auf. Jeder Längssteg 16 ist mit einem Kernloch 18 versehen. Somit kann das Etagenschirmblech 2 mit den Seitenwänden des Baugruppenträgers direkt verschraubt werden, wobei die Dichtheit dieser Verbindung und damit der vorbestimmte Dämpfungswert in Abhängigkeit des Abstandes der Längsstege 16 variiert werden kann. Diese Längsstege 16 dienen aber auch für die Versteifung des Baugruppenträgers bzw. als Stütze für die Führungsschienen des Baugruppenträgers. Die Längsgewinde 8 der beiden Schenkel 4 und 6 sind dafür vorgesehen, daß weitere Abschirmkomponenten, beispielsweise Frontplatten und ein Verdrahtungsschirmblech, mechanisch und elektrisch leitend mit dem Etagenschirmblech 2 verbunden werden könnten. Somit erhält man einen rundum abgeschirmten Baugruppenträger.

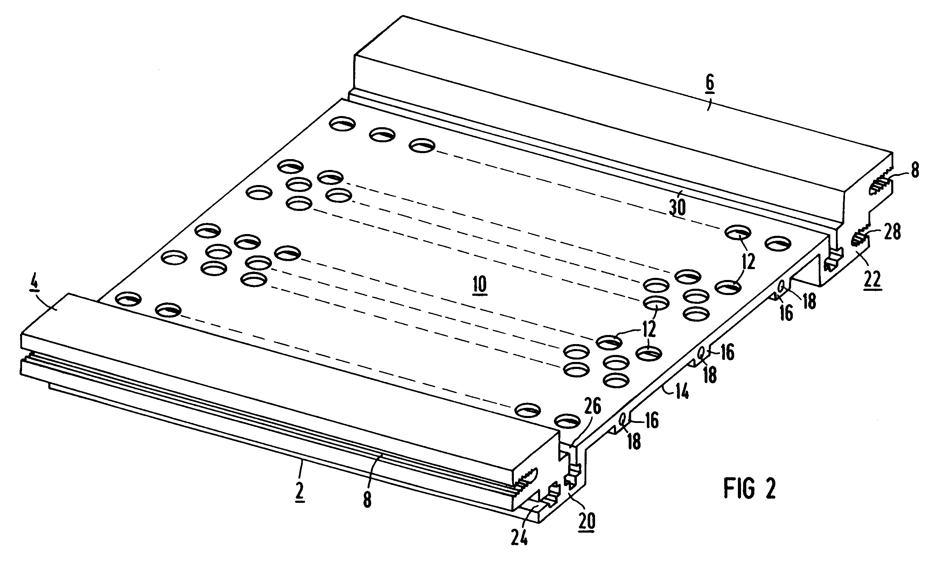

In Figur 2 ist eine weitere Ausführungsform des Etagenschirmbleches 2 nach Figur 1 dargestellt, wobei gleiche Bezugszeichen gleiche Elemente des Etagenschirmblechs 2 bezeichnen. Bei dieser Ausführungsform des Etagenschirmbleches 2 sind auf der Seite 14 des perforierten Stegbleches 10 im Bereich der Schenkel 4 und 6 parallel zu den Längsstegen 16 eine vordere und hintere Querschiene 20 und 22 eines Baugruppenträgers einstückig angeordnet. Die vordere Querschiene 20 ist mit zwei rechtwinklig zueinander angeordneten nutförmigen Aufnahmen 24 und 26 versehen, die von Stirnseite zu Stirnseite der Querschiene 20 verlaufen. Dabei zeigt die Öffnung der nutförmigen Aufnahme 24 zur Einschubrichtung der Steckbaugruppen und die Öffnung der nutförmigen Aufnahme 26 ist im Stegblech 10 angeordnet. In diesen Aufnahmen 24 und 26 können Kontaktmittel, die aus Übersichtlichkeitsgründen nicht dargestellt sind, eingeschoben werden. Die hintere Querschiene 22 ist einerseits mit einem Längsgewinde 28 und andererseits mit einer nutförmigen Aufnahme 30 für ein Kontaktmittel versehen, wobei das Längsgewinde 28 und die Aufnahme 30 rechtwinklig zueinander angeordnet sind. Das Längsgewinde 28 ist für die Befestigung einer Rückwandleiterplatte vorgesehen. Die Öffnung der nutförmigen Aufnahme 30 ist, wie die Öffnung der Aufnahme 26, im Stegblech 10 angeordnet. Außerdem ist der Abstand der beiden Querschienen 20 und 22 kleiner als der Abstand der beiden Schenkel 4 und 6. Somit benötigt man für die Erstellung eines Baugruppenträgers neben den beiden Etagenschirmblechen 2 nur noch zwei Seitenwände, die mit den Etagenschirmblechen 2 direkt verschraubt werden. Dadurch erhöht sich die Steifigkeit des Baugruppenträgers und der Dämpfungswert.

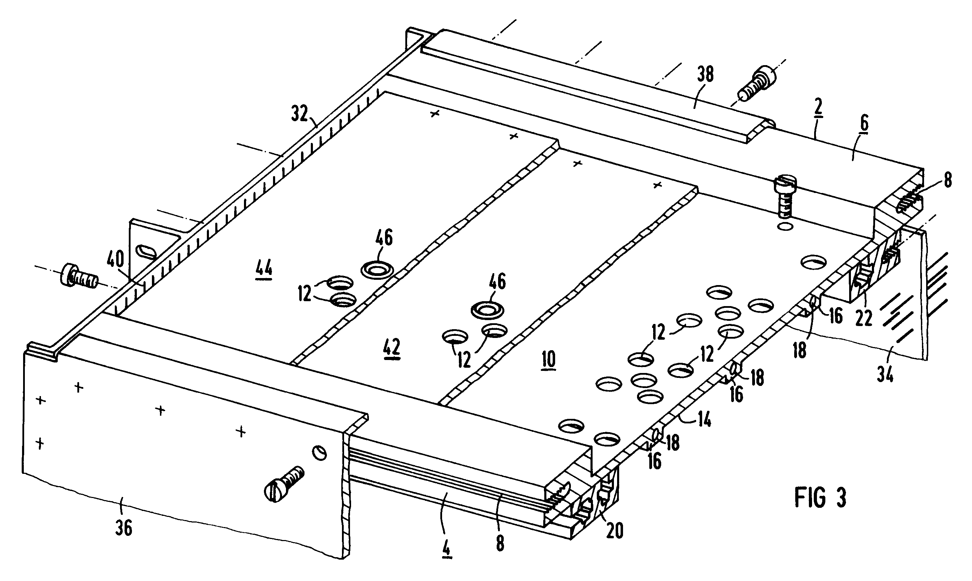

In Figur 3 ist ein Ausschnitt eines Baugruppenträgers mit Schirmkomponenten dargestellt. Vom Baugruppenträger sind teilweise die vordere und hintere Querschiene 20 und 22, eine linke Seitenwand 32, eine Rückwandleiterplatte 34, eine Frontplatte 36 und ein Verdrahtungsschirmblech 38 dargestellt. Alle Komponenten sind miteinander verschraubt, wobei zwischen der Seitenwand 32 und dem Etagenschirmblech 2 ein Kontaktstreifen 40 angeordnet ist. Um den Dämpfungswert des Etagenschirmbleches 2 zu erhöhen, ohne dabei die Dicke des Stegbleches 10 zu erhöhen, sind zwei weitere zusätzliche Bleche 42 und 44 auf dem Stegblech 10 paketiert. Das Lochbild dieser beiden zusätzlichen Bleche 42 und 44 entspricht dem Lochbild des Stegbleches 10. Die Bleche 42 und 44 und das Stegblech 10 sind mittels Rohrnieten 46 mechanisch und elektrisch leitend miteinander verbunden, die jeweils im Luftdurchtrittsbereich, d.h. im Stanzloch 12, eingesetzt sind. Dabei entspricht der Außendurchmesser jeder Rohrniete 46 dem Lochdurchmesser, wodurch der Luftdurchtritt nur unwesentlich eingeschränkt wird. Außerdem ist dieses paketierte Etagenschirmblech 2 mittels Schrauben mit den Querschienen 20 und 22 des Baugruppenträgers verbunden.

## Patentansprüche

1. Etagenschirmblech (2) für einen Baugruppenträger zur Abschirmung von hochfrequenten, elektromagnetischen Störfeldern, bestehend aus einem U-förmigen Profil, dessen Schenkel (4, 6) jeweils als Querschiene mit einem Längsgewinde (8) ausgebildet sind und dessen perforiertes Stegblech (10) auf der den Schenkeln (4, 6) abgewandten Seite (14) parallel zueinander und parallel zu den Schenkeln (4, 6) angeordnete Längsstege (16) aufweist, die jeweils ein Kernloch (18) aufweisen, wobei die Dicke des Stegbleches (10) und die Auslegung dessen Stanzlochbildes von den Dämpfungs- und Entwärmungsanforderungen der im Baugruppenträger angeordneten Steckbaugruppen abhängig sind.

2. Etagenschirmblech (2) nach Anspruch 1, **dadurch** **gekennzeichnet,** daß auf der Seite (14) des perforierten Stegbleches (10) im Bereich der Schenkel (4, 6) parallel zu den Längsstegen (16) eine vordere und eine hintere Querschiene (20, 22) eines Baugruppenträgers einstückig angeordnet sind.

3. Etagenschirmblech (2) nach Anspruch 1 oder 2, **dadurch** **gekennzeichnet**, daß wenigstens ein zusätzliches perforiertes Blech (42, 44) vorgesehen ist, dessen Stanzlochbild und Abmessungen denen des Stegbleches (10) entsprechen, wobei das Blech (42, 44) und das Stegblech (10) mittels in den Stanzlöchern (12) eingesetzter Rohrnieten (46) miteinander mechanisch und elektrisch leitend verbunden sind.

## Claims

1. Tier-shield sheet (2) for an assembly carrier for shielding high-frequency, electromagnetic disturbance fields, said sheet consisting of a U-shaped profile section, the side pieces (4, 6) of which are each formed as transverse rails with a longitudinal thread (8) and the perforated web sheet (10) of which has on the side (14) remote from the side pieces (4, 6) longitudinal webs (16) which are arranged so as to be parallel to each other and parallel to the side pieces (4, 6) and each of which has a tap hole (18), with the thickness of the web sheet (10) and the layout of its punched hole pattern being dependent upon the damping and heat-dissipation requirements of the plug-in assemblies arranged in the assembly carrier.

2. Tier-shield sheet (2) according to claim 1, characterised in that a front and a rear transverse rail (20, 22) of an assembly carrier are arranged in one piece with and on the side (14) of the perforated web sheet (10), in the region of the side pieces (4, 6), parallel to the longitudinal webs (16).

3. Tier-shield sheet (2) according to claim 1 or 2, characterised in that at least one additional perforated sheet (42, 44) is provided, the punched hole pattern and dimensions of which correspond to those of the web sheet (10), with the sheet (42, 44) and the web sheet (10) being connected with each other in a mechanical and electrically conductive manner by means of tubular rivets (46) inserted in the punched holes (12).

## Revendications

1. Tôle de blindage (2) d'étage pour un porte-modules pour réaliser le blindage vis-à-vis de champs électromagnétiques parasites à haute fréquence, constituée par un profilé en forme de U, dont les branches (4,6) sont réalisées respectivement sous la forme de rails transversaux comportant un filetage longitudinal (8) et dont la base en tôle perforée (10) possède, sur la face (14) tournée à l'opposé des branches (4,6), des barrettes longitudinales (16), qui sont parallèles entre elles et aux branches (4,6) et qui possèdent respectivement un avant-trou (18), l'épaisseur de la base en tôle (10) et la configuration du réseau de trous perforés de cette base dépendant des exigences du point de vue affaiblissement et évacuation de chaleur des modules enfichables disposés dans le porte-modules.

2. Tôle de blindage (2) d'étage suivant la revendication 1, caractérisée par le fait qu'un rail transversal avant et un rail transversal arrière (20,22) d'un porte-modules sont disposés d'un seul tenant sur la face (14) de la base en tôle perforée (10) au voisinage des branches (4,6), parallèlement aux barrettes longitudinales (16).

3. Tôle de blindage (2) d'étage suivant la revendication 1 ou 2, caractérisée par le fait qu'il est prévu au moins une tôle perforée supplémentaire (42,44), dont le réseau des trous poinçonnés et les dimensions correspondent à celui et à celles de la base en tôle (10), la tôle (42,44) et la base en tôle (10) étant reliées entre elles mécaniquement et d'une manière électriquement conductrice au moyen de rivets tubulaires (46) insérés dans les trous poinçonnés (12).
